# EUROPÄISCHE PATENTANMELDUNG

(11) **EP 2 093 581 A1**
(43) Veröffentlichungstag der Anmeldung: **26.08.2009**
(21) Anmeldenummer: 09001573.6
(22) Anmeldetag: 05.02.2009
(51) Int. Cl.: G01R 31/327, A47L 15/42, D06F 58/26, D06F 58/28, D06F 39/04, H01H 47/00, G05B 9/02, G05B 23/02

(54) **Steuergerät für ein Haushaltsgerät, Haushaltsgerät und zugehöriges Verfahren**

(30) Priorität: 19.02.2008 DE 102008011495
(71) Anmelder: E.G.O. Control Systems GmbH, 72336 Balingen-Frommern (DE)
(72) Erfinder: Henle, Thomas, 72414 Rangendingen (DE); Gottlieb, Harald, 72336 Balingen (DE); Beck, Walter, 72459 Albstadt (DE); Streifler, Rolf, 72367 Weilen (DE)
(74) Vertreter: Baumann, Jörg

(57) **Zusammenfassung**

Ein Steuergerät (1200) zur Funktionssteuerung eines Haushaltsgerätes (1000) umfasst eine Überwachungseinrichtung zur Überwachung der ordnungsgemäßen Funktion des Haushaltsgeräts (1000) mit mindestens einem Überwachungsanschluss (K1, K2), der mit mindestens einem zugehörigen Auswerteknoten (A1, A2) innerhalb eines Leistungsteils (1100) des Haushaltsgeräts zu verbinden ist, und einer Auswerteeinrichtung (1201), die ein an dem mindestens einen Überwachungsanschluss (K1, K2) anstehendes Signal zur Überwachung der ordnungsgemäßen Funktion des Haushaltsgeräts(1000) auswertet.

## Beschreibung

Die Erfindung betrifft ein Steuergerät für ein Haushaltsgerät, ein Haushaltsgerät und ein Verfahren zur Überwachung der ordnungsgemäßen Funktion eines Haushaltsgeräts.

Haushaltsgeräte, beispielsweise Wäschetrockner, umfassen üblicherweise elektrische, mit Netzwechselspannung betriebene Verbraucher, denen Schaltmittel, beispielsweise in Form von Relais, zugeordnet sind, wobei die Schaltmittel in Abhängigkeit von ihrem Schaltzustand die elektrischen Verbraucher mit der Netzwechselspannung beaufschlagen oder von dieser trennen. Die Schaltmittel werden geeignet von einem Steuergerät des Haushaltsgeräts angesteuert, um eine wunschgemäße Funktion des Haushaltsgeräts sicherzustellen.

Um eine erhöhte Betriebssicherheit des Haushaltsgeräts sicherzustellen und eine mögliche Gefährdung von Benutzern auszuschließen ist es wünschenswert, dass eine Fehlfunktion des Haushaltsgeräts, beispielsweise aufgrund eines Defekts eines Schaltmittels aufgrund von Verschleiß, sicher automatisch erkannt wird. Wenn eine Fehlfunktion erkannt ist, kann das Haushaltsgerät in einen sicheren Zustand überführt werden.

Ein Verfahren zum Betreiben eines Haushaltsgeräts, bei dem das Haushaltsgerät auf Fehlfunktionen hin überprüft wird, ist beispielsweise in der DE 10 2006 004 387 A1 beschrieben.

### Aufgabe und Lösung

Der Erfindung liegt die Aufgabe zugrunde, ein Steuergerät für ein Haushaltsgerät, ein Haushaltsgerät und ein Verfahren zur Überwachung der ordnungsgemäßen Funktion eines Haushaltsgeräts zur Verfügung zu stellen, welche die Betriebssicherheit erhöhen und einfach und kostengünstig herstellbar bzw. realisierbar sind.

Die Erfindung löst diese Aufgabe durch ein Steuergerät nach Anspruch 1, ein Haushaltsgerät nach Anspruch 8 sowie ein Verfahren nach Anspruch 13. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Das erfindungsgemäße Steuergerät dient zur Funktionssteuerung eines Haushaltsgerätes, insbesondere eines Wäschetrockners. Das Haushaltsgerät umfasst einen Leistungsteil mit elektrischen, mit Netzwechselspannung betriebenen Verbrauchern, Schaltmitteln, die durch das Steuergerät angesteuert sind, wobei jedem Verbraucher ein einzelnes der Schaltmittel zugeordnet ist, das in Abhängigkeit von seinem Schaltzustand seinen zugeordneten Verbraucher mit einem Pol der Netzwechselspannung verbindet oder von dem Pol der Netzwechselspannung trennt, und mindestens einem durch das Steuergerät angesteuerten zentralen Schaltmittel, das in Abhängigkeit von seinem Schaltzustand alle Verbraucher mit dem anderen Pol der Netzwechselspannung verbindet oder von dem anderen Pol der Netzwechselspannung trennt. Das zentrale Schaltmittel ermöglicht eine Sammelabschaltung aller elektrischen Verbraucher. Die den einzelnen Verbrauchern zugeordneten Schaltmittel ermöglichen ein individuelles An- bzw. Abschalten des zugehörigen Verbrauchers. Das Steuergerät umfasst eine Überwachungseinrichtung zur Überwachung der ordnungsgemäßen Funktion des Haushaltsgeräts. Die Überwachungseinrichtung umfasst mindestens einen Überwachungsanschluss, der bei einer Montage des Steuergeräts in das Haushaltsgerät mit mindestens einem zugehörigen Auswerteknoten innerhalb des Leistungsteils elektrisch zu verbinden ist, und eine Auswerteeinrichtung, die ein an dem mindestens einen Überwachungsanschluss anstehendes Signal zur Überwachung der ordnungsgemäßen Funktion des Haushaltsgeräts auswertet. Das Steuergerät kann einen Mikroprozessor umfassen, wobei die Überwachungseinrichtung und die Auswerteeinrichtung zumindest teilweise in den Mikroprozessor integriert sein können. Im Kontext der Überwachung der ordnungsgemäßen Funktion des Haushaltsgeräts kann beispielsweise überwacht werden, ob die Schaltmittel ordnungsgemäß geöffnet bzw. geschlossen sind, ob die Schaltmittel gebrückt bzw. kurzgeschlossen sind, ob die elektrischen Verbraucher ansteuerbar sind, d.h. beispielsweise gebrückt bzw. kurzgeschlossen sind, usw.

In einer Weiterbildung des Steuergeräts ist genau ein einziger Überwachungsanschluss vorgesehen, der mit genau einem einzigen, zugehörigen Auswerteknoten innerhalb des Leistungsteils zu elektrisch verbinden ist. Aufgrund des geringen Verschaltungsaufwands ist das Steuergerät bzw. das Haushaltsgerät kostengünstig herstellbar.

In einer Weiterbildung des Steuergeräts umfasst die Überwachungseinrichtung einen ersten Widerstand und einen zweiten Widerstand, die seriell zwischen den Überwachungsanschluss und ein Bezugspotential der Überwachungseinrichtung, insbesondere Masse, eingeschleift sind, wobei die Auswerteeinrichtung ein an einem Verbindungsknoten des ersten und des zweiten Widerstands anstehendes Signal zur Überwachung der ordnungsgemäßen Funktion des Haushaltsgeräts auswertet. Es versteht sich, dass der erste Widerstand und/oder der zweite Widerstand durch eine Parallel- bzw. Reihenschaltung von Widerständen gebildet sein können

In einer alternativen Weiterbildung des Steuergeräts sind genau zwei Überwachungsanschlüsse vorgesehen

In einer Weiterbildung des Steuergeräts ist einer der beiden Überwachungsanschlüsse mit einem zugehörigen Auswerteknoten innerhalb des Leistungsteils elektrisch zu verbinden, der mit einem Pol der Netzwechselspannung elektrisch verbunden ist. Der Auswerteknoten kann direkt, d.h. ohne zwischengeschaltete Bauelemente, oder indirekt, d.h. mit zwischengeschalteten Bauelementen, mit dem Pol der Netzwechselspannung elektrisch verbunden bzw. gekoppelt sein. Bei dem Pol der Netzwechselspannung kann es sich beispielsweise um den Neutralleiter oder einen der Außenleiter eines Drehstrom- bzw. Wechselstromnetzes handeln. Die elektrische Kopplung eines Überwachungsknotens mit der Netzwechselspannung ermöglicht eine Bestimmung der Phasenlage der Netzwechselspannung, wobei das Signal an dem anderen Überwachungsanschluss synchron zu einer definierten Phasenlage der Netzwechselspannung gemessen werden kann. Auf diese Weise kann die ordnungsgemäße Funktion des Haushaltsgeräts zuverlässiger überwacht werden, da ein Einfluss der Phasenlage bei der Messung berücksichtigt werden kann.

In einer Weiterbildung des Steuergeräts umfasst die Überwachungseinrichtung einen ersten Widerstand und einen zweiten Widerstand, die seriell zwischen einen ersten der beiden Überwachungsanschlüsse und ein Bezugspotential der Überwachungseinrichtung, insbesondere Masse, eingeschleift sind, sowie einen dritten Widerstand und einen vierten Widerstand, die seriell zwischen einen zweiten der beiden Überwachungsanschlüsse und das Bezugspotential eingeschleift sind, wobei die Auswerteeinrichtung ein an einem Verbindungsknoten des ersten und des zweiten Widerstands anstehendes Signal und ein an einem Verbindungsknoten des dritten und des vierten Widerstands anstehendes Signal zur Überwachung der ordnungsgemäßen Funktion des Haushaltsgeräts auswertet.

In einer Weiterbildung des Steuergeräts weist die Überwachungseinrichtung einen Analog-Digital-Wandler auf, der das an dem mindestens einen Überwachungsanschluss anstehende Signal oder ein daraus abgeleitetes Signal digitalisiert.

Das erfindungsgemäße Haushaltsgerät, insbesondere ein Wäschetrockner, umfasst einen Leistungsteil mit elektrischen, mit Netzwechselspannung betriebenen Verbrauchern, ansteuerbaren Schaltmitteln, wobei jedem Verbraucher ein einzelnes der Schaltmittel zugeordnet ist, das in Abhängigkeit von seinem Schaltzustand seinen zugeordneten Verbraucher mit einem Pol der Netzwechselspannung verbindet oder von dem Pol der Netzwechselspannung trennt, und mindestens einem ansteuerbaren zentralen Schaltmittel, das in Abhängigkeit von seinem Schaltzustand alle Verbraucher mit dem anderen Pol der Netzwechselspannung verbindet oder von dem anderen Pol der Netzwechselspannung trennt. Weiterhin umfasst das Haushaltsgerät ein oben beschriebenes, erfindungsgemäßes Steuergerät.

In einer Weiterbildung des Haushaltsgeräts sind die Schaltmittel Relais.

In einer Weiterbildung des Haushaltsgeräts umfassen die Verbraucher mindestens einen Motor und mindestens eine elektrische Heizung.

In einer Weiterbildung des Haushaltsgeräts ist zwischen den einen Pol der Netzwechselspannung und einen ersten und einen zweiten Verbraucher der Verbraucher das zentrale Schaltmittel eingeschleift, zwischen den ersten Verbraucher und den anderen Pol der Netzwechselspannung ein erstes Schaltmittel der Schaltmittel eingeschleift und zwischen den zweiten Verbraucher und den anderen Pol der Netzwechselspannung ein zweites Schaltmittel der Schaltmittel eingeschleift, wobei der mindestens eine Überwachungsanschluss der Überwachungseinrichtung alternativ mit einem Verbindungsknoten des ersten Verbrauchers und des ersten Schaltmittels, einem Verbindungsknoten des zweiten Verbrauchers und des zweiten Schaltmittels oder einem Verbindungsknoten des zentralen Schaltmittels und des ersten und des zweiten Verbrauchers verbunden ist.

In einer Weiterbildung des Haushaltsgeräts sind genau zwei Überwachungsanschlüsse vorgesehen, wobei einer der beiden Überwachungsanschlüsse mit einem zugehörigen Auswerteknoten innerhalb des Leistungsteils verbunden ist, der mit einem Pol der Netzwechselspannung verbunden ist.

Das erfindungsgemäße Verfahren zur Überwachung der ordnungsgemäßen Funktion eines oben genannten Haushaltsgeräts umfasst die Schritte: Einstellen einer definierten Schaltstellung der Schaltmittel, Messen des an dem mindestens einen Überwachungsanschluss anstehenden Signals, Vergleichen des gemessenen Signals mit einem gespeicherten Signal, das der definierten Schaltstellung zugeordnet ist, Bestimmen einer ordnungsgemäßen Funktion des Haushaltsgeräts, wenn das gemessene Signal mit dem gespeicherten Signal übereinstimmt, und Bestimmen einer nicht ordnungsgemäßen Funktion des Haushaltsgeräts und Ansteuern der Schaltmittel derart, dass sich ein möglichst sicherer bzw. maximal sicherer Zustand des Haushaltsgeräts einstellt, insbesondere Öffnen aller Schaltmittel, wenn das gemessene Signal mit dem gespeicherten Signal nicht übereinstimmt.

In einer Weiterbildung des Verfahrens sind zwei Überwachungsanschlüsse vorgesehen, wobei einer der beiden Überwachungsanschlüsse mit einem zugehörigen Auswerteknoten innerhalb des Leistungsteils verbunden ist, der mit einem Pol der Netzwechselspannung verbunden ist, wobei die Phasenlage der Netzwechselspannung durch Auswerten des Signals an dem einen Überwachungsanschluss bestimmt wird und das Signal an dem anderen Überwachungsanschluss synchron zu einer definierten Phasenlage der Netzwechselspannung gemessen wird, wobei die ordnungsgemäße Funktion des Haushaltsgeräts in Abhängigkeit von der Phasenlage bzw. dem gemessenen Signal an dem einen Überwachungsanschluss und dem gemessenen Signal an dem anderen Überwachungsanschluss, d.h. durch Auswerten der Signale an beiden Überwachungsanschlüssen, bestimmt wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

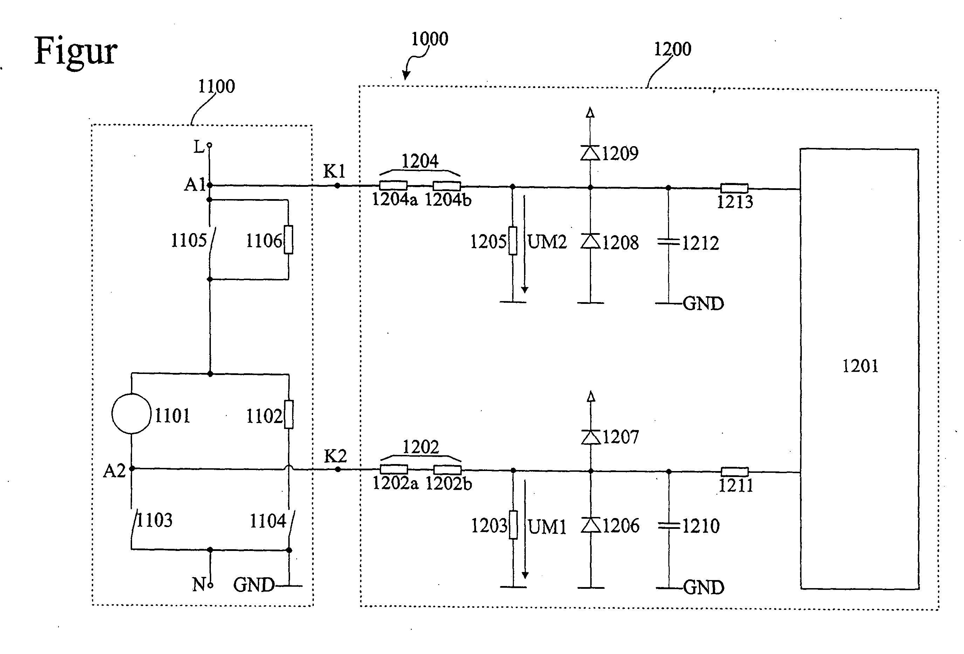

Vorteilhafte Ausführungsformen der Erfindung sind in der Zeichnung schematisch dargestellt und werden nachfolgend beschrieben. Hierbei zeigt die einzige Figur:
- Figur: ein erfindungsgemäßes Haushaltsgerät mit einem Steuergerät zur Funktionssteuerung und Funktionsüberwachung.

### Detaillierte Beschreibung der Zeichnungen

Wenn ein Element als mit einem anderen Element "verbunden" oder "gekoppelt" bezeichnet wird, können die Elemente direkt, d.h. ohne zwischengeschaltete Elemente, miteinander verbunden bzw. gekoppelt sein oder es können zwischengeschaltete Elemente vorhanden sein. Wenn ein Element jedoch als mit einem anderen Element "direkt verbunden" oder "direkt gekoppelt" bezeichnet wird, sind keine zwischengeschalteten Elemente vorhanden.

Die Figur zeigt ein Haushaltsgerät in Form eines Wäschetrockners 1000 mit einem Leistungsteil 1100 und einem Steuergerät 1200 zur Funktionssteuerung des Wäschetrockners 1000.

Der Leistungsteil 1100 umfasst elektrische, mit Netzwechselspannung betriebene Verbraucher in Form eines Motors 1101 und einer elektrischen Heizung 1102, ansteuerbare Schaltmittel in Form von Relais 1103 und 1104, wobei jedem der Verbraucher 1101 und 1102 ein einzelnes der Relais 1103 und 1104 zugeordnet ist, das in Abhängigkeit von seinem Schaltzustand seinen zugeordneten Verbraucher mit einem Pol N der Netzwechselspannung verbindet oder von dem Pol N der Netzwechselspannung trennt, und mindestens ein ansteuerbares zentrales Schaltmittel in Form eines Relais 1105, das in Abhängigkeit von seinem Schaltzustand alle Verbraucher 1101 und 1102 mit dem anderen Pol L der Netzwechselspannung verbindet oder von dem anderen Pol L der Netzwechselspannung trennt. Dem zentralen Relais 1105 ist ein hochohmiger Koppelwiderstand 1106 parallel geschaltet.

Im Leistungsteil 1100 ist zwischen den Pol L der Netzwechselspannung, vorliegend ein Außenleiter eines Drehstromnetzes, und die Verbraucher 1101 und 1102 das zentrale Schaltmittel bzw. Relais 1105 eingeschleift, zwischen den Motor 1101 und den anderen Pol N der Netzwechselspannung ist das Relais 1103 eingeschleift und zwischen die elektrische Heizung 1102 und den anderen Pol N der Netzwechselspannung ist das Relais 1104 eingeschleift, wobei ein Auswerteknoten A1 von dem Pol L der Netzwechselspannung gebildet wird und ein Auswerteknoten A2 von einem Verbindungsknoten des Motors 1101 und dem zugehörigen Relais 1103 gebildet wird.

Das Steuergerät 1200 dient unter anderem zur Ansteuerung der Relais 1103, 1104 und 1105 sowie zur Überwachung der ordnungsgemäßen Funktion des Haushaltsgeräts 1000. Im Kontext der Überwachung der ordnungsgemäßen Funktion des Haushaltsgeräts 1000 kann beispielsweise überwacht werden, ob die Relais 1103, 1104 und 1105 ordnungsgemäß, d.h. wie angesteuert, geöffnet bzw. geschlossen sind, ob die Relais gebrückt bzw. kurzgeschlossen sind, ob die elektrischen Verbraucher 1101 und 1102 ansteuerbar sind, d.h. beispielsweise gebrückt bzw. kurzgeschlossen sind, und/oder ob Fehler innerhalb des Steuergeräts vorliegen.

Zur Überwachung der ordnungsgemäßen Funktion des Haushaltsgeräts 1000 umfasst das Steuergerät 1200 eine Überwachungseinrichtung mit zwei Überwachungsanschlüssen K1 und K2, wobei der Überwachungsanschluss K1 mit dem Auswerteknoten A1 des Leistungsteils 1100 und der Überwachungsanschluss K2 mit dem Auswerteknoten A2 des Leistungsteils 1100 elektrisch verbunden ist. Die Überwachungseinrichtung umfasst weiter eine Auswerteeinrichtung in Form eines Mikroprozessors 1201, wobei der Mikroprozessor 1201 die an den Überwachungsanschlüssen K1 und K2 anstehenden Signale bzw. daraus abgeleitete Signale UM1 und UM2 zur Überwachung der ordnungsgemäßen Funktion des Haushaltsgeräts 1000 auswertet.

Zur Aufbereitung der an den Überwachungsanschlüssen K1 und K2 anstehenden Signale umfasst die Überwachungseinrichtung 1200 weiter einen ersten Widerstand 1202, bestehend aus in Reihe geschalteten Teilwiderständen 1202a und 1202b, und einen zweiten Widerstand 1203, wobei die Widerstände 1202 und 1203 seriell zwischen den Überwachungsanschluss K2 und Masse GND Masse eingeschleift sind. Ein dritter Widerstand 1204, bestehend aus in Reihe geschalteten Teilwiderständen 1204a und 1204b, und ein vierter Widerstand 1205 sind seriell zwischen den Überwachungsanschluss K1 und Masse GND eingeschleift.

Ein erster Eingang des Mikroprozessors 1201 ist mit einem Verbindungsknoten des ersten und des zweiten Widerstands 1202 und 1203 verbunden und ein zweiter Eingang des Mikroprozessors 1201 ist mit einem Verbindungsknoten des dritten und des vierten Widerstands 1204 und 1205 verbunden, wobei ein nicht gezeigter Analog-Digital-Wandler des Mikroprozessors 1201 die an den jeweiligen Verbindungsknoten anstehenden Signale UM1 bzw. UM2 digitalisiert und der Mikroprozessor 1201 die digitalisierten Signale zur Überwachung der ordnungsgemäßen Funktion des Haushaltsgeräts 1000 auswertet. Dioden 1206 und 1207 sowie 1208 und 1209 dienen als Klemmdioden zum Überspannungsschutz der zugehörigen Eingänge des Mikroprozessors 1201. Optionale Kondensatoren 1210 und 1212 sowie optionale Widerstände 1211 und 1213 dienen als Filter und Schutz der zugehörigen Eingänge des Mikroprozessors 1201.

Zur Funktionsüberwachung steuert die Überwachungseinrichtung bzw. deren Mikroprozessor 1201 zunächst die Relais 1103, 1104 und 1105 derart an, dass sich eine definierte Schaltstellung aller Relais 1103, 1104 und 1105 ergibt. Eine solch definierte Schaltstellung kann einen Zustand umfassen, bei dem alle Relais 1103, 1104 und 1105 geöffnet sind. Anschließend wird die Phasenlage der Netzwechselspannung durch Auswerten des Signals an dem Überwachungsanschluss K1 bestimmt. Beispielsweise kann ein Maximum einer positiven Halbwelle der Netzwechselspannung bestimmt werden, indem das Signal UM2 abgetastet wird, wobei das Maximum dann vorliegt, wenn keine Zunahme des Signals UM2 mehr stattfindet. Wenn das Maximum detektiert ist, kann das Signal UM1 unmittelbar anschließend eingelesen und digitalisiert werden, d.h. das Signal UM1 wird synchron zu einer definierten Phasenlage der Netzwechselspannung gemessen.

Wenn alle Relais 1103, 1104 und 1105 geöffnet sind und auch im Steuergerät 1200 keine Fehler vorliegen, müssen die gemessenen bzw. abgetasteten Werte der Signal UM1 und UM2 vorbekannte Werte aufweisen, die im Mikroprozessor gespeichert sind. Bei ordnungsgemäßer Funktion stellt sich im vorliegenden Fall als Spannung UM2 eine periodische Spannung ein, die bei einer positiven Halbwelle der Netzspannung zur Netzspannung proportional ist und die bei einer negativen Halbwelle der Netzspannung aufgrund der Klemmwirkung der Diode 1208 in etwa der Massespannung entspricht. Die Spannung UM1 entspricht in ihrem qualitativen Verlauf der Spannung UM2, wobei das Verhältnis zwischen den Spannungen UM1 und UM2 durch den Wert der Widerstände 1202, 1203, 1204, 1205 und 1106 festgelegt ist. Das, insbesondere synchronisierte, Messen der Spannung UM1 alleine, das Messen beider Spannungen UM1 und UM2 und/oder das Bilden des Verhältnisses der Spannungen UM1 und UM2 kann folglich als Plausibilitätsüberprüfung zum Funktionstest herangezogen werden. Das synchronisierte Messen der Spannung UM1 ermöglicht eine Kompensation von Störeffekten, die auftreten können, wenn ein Netzstecker des Haushaltsgeräts verpolt eingesteckt wird, d.h. wenn die Pole N und L der Netzspannung im Vergleich zu der in der Figur dargestellten Form vertauscht sind.

Wenn eine Übereinstimmung der abgetasteten mit den gespeicherten Werten vorliegt, kann auf eine ordnungsgemäße Funktion des Haushaltsgerätes 1000 geschlossen werden. Andernfalls kann auf eine nicht ordnungsgemäße Funktion des Haushaltsgerätes 1000 geschlossen werden, worauf die Relais geöffnet bleiben.

Die Überprüfung kann fortgesetzt werden, indem die Schaltzustände der Relais 1103, 1104 und 1105 verändert werden und erneut die Signale UM1 und UM2 wie oben beschrieben ausgewertet werden. Das Signal UM1 kann bei einem Maximum der positiven Halbwelle der Netzwechselspannung eingelesen werden, zusätzlich oder alternativ jedoch auch während einer negativen Halbwelle der Netzwechselspannung und/oder bei einem positiven oder negativen Nulldurchgang der Netzwechselspannung.

Alternativ zu der in der Figur dargestellten Ausführungsform kann der obere Auswertezweig mit dem Überwachungsanschluss K1, den Widerständen 1204, 1205 und 1213, den Dioden 1208 und 1209 sowie dem Kondensator 1212 entfallen. Die Messung der Spannung UM1 erfolgt dann nicht synchron zur Netzspannung. Auch für diesen Fall müssen sich jedoch für definierte Schaltzustände der Relais 1103, 1104 und 1105 definierte Verläufe bzw. Werte der Spannung UM1 ergeben, vorausgesetzt es liegt keine Funktionsstörung vor.

Es versteht sich, dass weitere elektrische Verbraucher und dazu in Reihe geschaltete, zugehörige Schaltmittel den Verbrauchern 1101 und 1102 sowie deren zugehörigen Schaltmitteln 1103 bzw. 1104 in entsprechender Weise parallel geschaltet sein können.

Der Auswerteknoten kann alternativ auch durch einen Verbindungsknoten des zweiten Verbrauchers 1102 und dem zugehörigen Schaltmittel 1104 oder durch einen Verbindungsknoten der beiden Verbraucher 1101 und 1102 sowie des zentralen Schaltmittels 1105 gebildet sein.

## Patentansprüche

1. Steuergerät (1200) zur Funktionssteuerung eines Haushaltsgerätes (1000), insbesondere eines Wäschetrockners,
- wobei das Haushaltsgerät (1000) einen Leistungsteil (1100) aufweist, mit
- elektrischen, mit Netzwechselspannung betriebenen Verbrauchern (1101,1102),
- Schaltmitteln (1103,1104), die durch das Steuergerät (1200) angesteuert sind, wobei jedem Verbraucher (1101, 1102) ein einzelnes der Schaltmittel (1103,1104) zugeordnet ist, das in Abhängigkeit von seinem Schaltzustand seinen zugeordneten Verbraucher (1101,1102) mit einem Pol (N) der Netzwechselspannung verbindet oder von dem Pol (N) der Netzwechselspannung trennt, und
- mindestens einem durch das Steuergerät (1200) angesteuerten zentralen Schaltmittel (1105), das in Abhängigkeit von seinem Schaltzustand alle Verbraucher (1101, 1102) mit dem anderen Pol (L) der Netzwechselspannung verbindet oder von dem anderen Pol (L) der Netzwechselspannung trennt,
wobei das Steuergerät (1200) aufweist:
- eine Überwachungseinrichtung zur Überwachung der ordnungsgemäßen Funktion des Haushaltsgeräts (1000) mit
- mindestens einem Überwachungsanschluss (K1, K2), der mit mindestens einem zugehörigen Auswerteknoten (A1, A2) innerhalb des Leistungsteils (1100) zu verbinden ist, und
- einer Auswerteeinrichtung (1201), die ein an dem mindestens einen Überwachungsanschluss (K1, K2) anstehendes Signal zur Überwachung der ordnungsgemäßen Funktion des Haushaltsgeräts(1000) auswertet.

2. Steuergerät nach Anspruch 1, **dadurch gekennzeichnet, dass** genau ein einziger Überwachungsanschluss (K2) vorgesehen ist, der mit genau einem einzigen, zugehörigen Auswerteknoten (A2) innerhalb des Leistungsteils (1100) zu verbinden ist.

3. Steuergerät nach Anspruch 2, **dadurch gekennzeichnet, dass** die Überwachungseinrichtung (1200) einen ersten Widerstand (1202) und einen zweiten Widerstand (1203) umfasst, die seriell zwischen den Überwachungsanschluss (K2) und ein Bezugspotential der Überwachungseinrichtung (1200), insbesondere Masse (GND), eingeschleift sind, wobei die Auswerteeinrichtung (1201) ein an einem Verbindungsknoten des ersten und des zweiten Widerstands (1202, 1203) anstehendes Signal (UM1) zur Überwachung der ordnungsgemäßen Funktion des Haushaltsgeräts (1000) auswertet.

4. Steuergerät nach Anspruch 1, **dadurch gekennzeichnet, dass** genau zwei Überwachungsanschlüsse (K1, K2) vorgesehen sind.

5. Steuergerät nach Anspruch 4, **dadurch gekennzeichnet, dass** ein Überwachungsanschluss (K1) der beiden Überwachungsanschlüsse (K1, K2) mit einem zugehörigen Auswerteknoten (A1) innerhalb des Leistungsteils (1100) zu verbinden ist, der mit einem Pol (L) der Netzwechselspannung verbunden ist.

6. Steuergerät nach Anspruch 4 oder 5, **dadurch gekennzeichnet, dass** die Überwachungseinrichtung (1200) aufweist:
- einen ersten Widerstand (1202) und einen zweiten Widerstand (1203), die seriell zwischen einen ersten Überwachungsanschluss (K2) der beiden Überwachungsanschlüsse (K1, K2) und ein Bezugspotential (GND) der Überwachungseinrichtung (1200), insbesondere Masse, eingeschleift sind, und
- einen dritten Widerstand (1204) und einen vierten Widerstand (1205), die seriell zwischen einen zweiten Überwachungsanschluss (K1) der beiden Überwachungsanschlüsse (K1, K2) und das Bezugspotential (GND) eingeschleift sind,
- wobei die Auswerteeinrichtung (1201) ein an einem Verbindungsknoten des ersten und des zweiten Widerstands (1202, 1203) anstehendes Signal (UM1) und ein an einem Verbindungsknoten des dritten und des vierten Widerstands (1204, 1205) anstehendes Signal (UM2) zur Überwachung der ordnungsgemäßen Funktion des Haushaltsgeräts (1000) auswertet.

7. Steuergerät nach einem der vorhergehenden Ansprüche, **dadurch gekennzeichnet, dass** die Überwachungseinrichtung einen Analog-Digital-Wandler aufweist, der das an dem mindestens einen Überwachungsanschluss anstehende Signal (UM1, UM2) digitalisiert.

8. Haushaltsgerät (1000), insbesondere Wäschetrockner, mit
- einem Leistungsteil (1100), mit
- elektrischen, mit Netzwechselspannung betriebenen Verbrauchern (1101, 1102),
- ansteuerbaren Schaltmitteln (1103, 1104), wobei jedem Verbraucher (1101, 1102) ein einzelnes der Schaltmittel (1103, 1104) zugeordnet ist, das in Abhängigkeit von seinem Schaltzustand seinen zugeordneten Verbraucher mit einem Pol (N) der Netzwechselspannung verbindet oder von dem Pol (N) der Netzwechselspannung trennt, und
- mindestens einem ansteuerbaren zentralen Schaltmittel (1105), das in Abhängigkeit von seinem Schaltzustand alle Verbraucher (1101, 1102) mit dem anderen Pol (L) der Netzwechselspannung verbindet oder von dem anderen Pol (L) der Netzwechselspannung trennt,
**gekennzeichnet durch**
- ein Steuergerät (1200) nach einem der Ansprüche 1 bis 7.

9. Haushaltsgerät nach Anspruch 8, **dadurch gekennzeichnet, dass** die Schaltmittel Relais (1103, 1104, 1105) sind.

10. Haushaltsgerät nach Anspruch 8 oder 9, **dadurch gekennzeichnet, dass** die Verbraucher einen Motor (1101) und eine elektrische Heizung (1102) umfassen.

11. Haushaltsgerät nach einem der Ansprüche 8 bis 10, **dadurch gekennzeichnet, dass** zwischen den einen Pol (L) der Netzwechselspannung und einen ersten und einen zweiten Verbraucher (1101, 1102) der Verbraucher das zentrale Schaltmittel (1105) eingeschleift ist, zwischen den ersten Verbraucher (1101) und den anderen Pol (N) der Netzwechselspannung ein erstes Schaltmittel (1103) der Schaltmittel eingeschleift ist und zwischen den zweiten Verbraucher (1102) und den anderen Pol (N) der Netzwechselspannung ein zweites Schaltmittel (1104) der Schaltmittel eingeschleift ist, wobei der mindestens eine Überwachungsanschluss (K2) der Überwachungseinrichtung (1200) alternativ mit einem Verbindungsknoten (A2) des ersten Verbrauchers (1101) und des ersten Schaltmittels (1103), einem Verbindungsknoten des zweiten Verbrauchers (1102) und des zweiten Schaltmittels (1104) oder einem Verbindungsknoten des zentralen Schaltmittels (1105) und des ersten und des zweiten Verbrauchers (1101, 1102) verbunden ist.

12. Haushaltsgerät nach einem der Ansprüche 8 bis 11, **dadurch gekennzeichnet, dass** genau zwei Überwachungsanschlüsse (K1, K2) vorgesehen sind und dass ein Überwachungsanschluss (K1) der beiden Überwachungsanschlüsse (K1, K2) mit einem zugehörigen Auswerteknoten (A1) innerhalb des Leistungsteils (1100) verbunden ist, der mit einem Pol (L) der Netzwechselspannung verbunden ist.

13. Verfahren zur Überwachung der ordnungsgemäßen Funktion eines Haushaltsgeräts (1000) nach einem der Ansprüche 8 bis 12, mit den Schritten
- Einstellen einer definierten Schaltstellung der Schaltmittel (1103, 1104, 1105),
- Messen eines an dem mindestens einen Überwachungsanschluss (K1, K2) anstehenden Signals,
- Vergleichen des gemessenen Signals mit einem gespeicherten Signal, das der definierten Schaltstellung zugeordnet ist,
- Bestimmen einer ordnungsgemäßen Funktion des Haushaltsgeräts (1000), wenn das gemessene Signal mit dem gespeicherten Signal übereinstimmt, und
- Bestimmen einer nicht ordnungsgemäßen Funktion des Haushaltsgeräts (1000) und Ansteuern der Schaltmittel (1103, 1104, 1105) derart, dass sich ein möglichst sicherer Zustand des Haushaltsgeräts (1000) einstellt, insbesondere Öffnen aller Schaltmittel (1103, 1104, 1105), wenn das gemessene Signal mit dem gespeicherten Signal nicht übereinstimmt.

14. Verfahren nach Anspruch 13, **dadurch gekennzeichnet, dass** genau zwei Überwachungsanschlüsse (K1, K2) vorgesehen sind und dass ein Überwachungsanschluss (K1) der beiden Überwachungsanschlüsse (K1, K2) mit einem zugehörigen Auswerteknoten (A1) innerhalb des Leistungsteils (1100) verbunden ist, der mit einem Pol (L) der Netzwechselspannung verbunden ist, wobei
- die Phasenlage der Netzwechselspannung durch Auswerten des Signals an dem einen Überwachungsanschluss (K1) bestimmt wird und
- das Signal an dem anderen Überwachungsanschluss (K2) synchron zu einer definierten Phasenlage der Netzwechselspannung gemessen wird, wobei
- die ordnungsgemäße Funktion des Haushaltsgeräts (1000) in Abhängigkeit von der Phasenlage und dem gemessenen Signal an dem anderen Überwachungsanschluss (K2) bestimmt wird.
